# EUROPEAN PATENT SPECIFICATION

(11) **EP 2 045 305 B1**
(45) Date of publication and mention of the grant of the patent: **27.09.2017**
(21) Application number: 07791231.9
(22) Date of filing: 24.07.2007
(51) Int. Cl.: C09J 167/02, C09J 7/02, C09J 163/02, G06K 19/077

(54) **HOT-MELT ADHESIVE FOR FIXING IC MODULE, AND LAMINATED TAPE AND IC CARD USING THE ADHESIVE**
SCHMELZHAFTKLEBER FÜR BEFESTIGUNG EINES IC-MODULS UND MEHRSCHICHTIGES BAND SOWIE CHIPKARTE MIT DEM KLEBER
ADHÉSIF THERMOFUSIBLE POUR FIXER UN MODULE DE CIRCUIT INTÉGRÉ, RUBAN STRATIFIÉ ET CARTE DE CIRCUIT INTÉGRÉ UTILISANT L'ADHÉSIF

(30) Priority: 25.07.2006 JP 2006202508
(43) Date of publication of application: 08.04.2009
(73) Proprietor: Toagosei Co., Ltd, Minato-ku, Tokyo 105-8419 (JP)
(72) Inventor: IMAHORI, Makoto, Nagoya-shi Aichi 455-0027 (JP)
(74) Representative: TBK
(86) International application number: PCT/JP2007/064506
(87) International publication number: WO 2008/013172

(56) References cited:
- WO-A1-99/29797
- JP-A- 2000 036 026
- JP-A- 2001 216 492
- JP-A- 2004 059 840
- JP-A- 2005 309 953

## Description

### [FIELD OF THE INVENTION]

The present invention relates to a hot-melt adhesive for fixing an IC module, and a laminated tape and an IC card formed using the same. More particularly, the present invention relates to a hot-melt adhesive for fixing an IC module having sufficient transparency, and excellent solvent resistance, moist heat resistance, heat resistance and the like, a laminated tape in which an adhesive tape formed using this adhesive and an IC module tape are laminated, and an IC card which is formed by bonding and fixing an IC module cut out from this laminated tape to a card body.

### [BACKGROUND ART]

In recent years, IC cards which are capable of recording more data in comparison to magnetic cards, and are hard to forge, since the data can be encrypted, are becoming widely used. In such an IC card, an IC module is fitted in a recessed part arranged in the card body made from a resin, and is bonded and fixed to the card body at the peripheral edge of the module, with a hot-melt adhesive. The IC card is sometimes subjected to deformation such as bending, impact and so on. The IC module must be firmly bonded and fixed to the card body so that the IC module neither detaches nor falls off the card body.

Additionally, the IC card is put to practical use currently as a card used in a vehicle for a toll road Electronic Toll Collection (ETC) system, a SIM (Subscriber Identity Module) card for a mobile telephone, and the like. The IC card is required to have solvent resistance to anticipate the attachment of fuel, alcoholic drink and so on; moist heat resistance, heat resistance and the like in to anticipate high temperature, high humidity atmosphere and the like inside a vehicle particularly in the summer or the like (see Patent Document 1).

The IC module bonded and fixed to the IC card is manufactured by cutting out an individual IC module in a way such as punching from an IC module tape in which an IC chip is disposed and sealed in each of a plurality of circuit patterns formed on the tape consisting of glass-epoxy and the like, in the length direction thereof. Furthermore, on this IC module tape, an adhesive tape is laminated and bonded. From this laminated tape, the IC module with which a hot-melt adhesive layer is bonded is cut out by a method such as punching. In this process, whether or not an IC chip is disposed in each circuit pattern is inspected. If transparency of the adhesive tape is low for this inspection, it imposes a problem that detection of the IC chip becomes difficult. Additionally, since the cutting-out is continuously performed, temperature of a punching blade and the like rises, and the adhesive may be fusion bonded to the punching blade and the like depending on the composition of the adhesive, which sometimes lowers workability.

JP-A 2003-27030 and JP-A 2000-36026 disclose different types of hot-melt adhesives used for bonding materials in the production of IC cards.

### [DISCLOSURE OF THE INVENTION]

### [PROBLEMS THAT THE INVENTION IS TO SOLVE]

The present invention is completed in view of the above-mentioned situation and the objective is to provide a hot-melt adhesive for fixing an IC module having sufficient transparency, and excellent solvent resistance, moist heat resistance, heat resistance and the like, a laminated tape in which an adhesive tape formed using this adhesive and an IC module tape are laminated, and an IC card which is formed by bonding and fixing an IC module cut out from the laminated tape to a card body.

### [MEANS FOR SOLVING THE PROBLEMS]

The present invention is as follows.
1. A hot-melt adhesive for fixing an IC module characterized in that the adhesive comprises a saturated polyester resin having a heat of fusion in the range from 8 mJ/mg to 25 mJ/mg and has a transmittance of 5% or higher when a film of the adhesive having a thickness of 30 µm is subjected to measurement by a visible light at a wavelength of 600 nm.
2. The hot-melt adhesive for fixing an IC module according to 1 above, wherein the adhesive comprises a saturated polyester resin which has a phthalic acid residue and a 1,4-butanediol residue, wherein the content of the phthalic acid residue is in the range from 30% to 80% by mole based on 100% by mole of a total of dicarboxylic acid residues, and wherein the content of the 1,4-butanediol residue is in the range from 30% by mole or more based on 100% by mole of a total of diol residues.
3. The hot-melt adhesive for fixing an IC module according to 2 above, wherein at least a part of the phthalic acid residue is a terephthalic acid residue, and wherein (a × b)/100 is in the range from 30% to 55% by mole where the ratio of the terephthalic acid residue is a % by mole based on 100% by mole of a total of the dicarboxylic acid residues and the ratio of the 1,4-butanediol residue is b % by mole based on 100% by mole of a total of the diol residues.
4. The hot-melt adhesive for fixing an IC module according to any one of 1 to 3 above, further comprising an epoxy resin.
5. The hot-melt adhesive for fixing an IC module according to 4 above, wherein the epoxy resin is a bisphenol A-type epoxy resin.
6. The hot-melt adhesive for fixing an IC module according to 5 above, wherein the epoxy resin is contained in an amount from 3 to 30 parts by weight based on 100 parts by weight of the saturated polyester resin.
7. A laminated tape characterized by comprising, an IC module tape that has an IC module substrate tape on which a plurality of circuit patterns are arranged in a length direction at intervals, IC chips which are disposed on a surface of the IC module substrate tape and are electrically connected with the respective circuit patterns, the number of which corresponds to the number of the IC chips, and a sealing part which seal the respective IC chips, and an adhesive tape which is formed using the hot-melt adhesive for fixing an IC module according to any one of 1 to 6 above and is bonded to the surface of the IC module substrate tape and to the respective sealing parts.
8. The laminated tape according to 7 above, wherein the IC module substrate tape is formed using a saturated polyester resin.
9. An IC card characterized by comprising, a card body, an IC module which is cut out from the IC module tape in the laminated tape according to 7 or 8 above, and an adhesive layer which is cut out together with the IC module from the adhesive tape in said laminated tape and bonds the card body and the IC module.
10. The IC card according to 9 above, wherein the card body is formed using a saturated polyester resin.

### [EFFECT OF THE INVENTION]

According to the hot-melt adhesive for fixing an IC module of the present invention, the adhesive can lead to an adhesive tape with sufficient transparency. Therefore, detection of an IC chip is easily performed. The adhesive also has excellent solvent resistance, moist heat resistance, heat resistance and so on, thereby being useful as an adhesive for bonding an IC module to the card body in an IC card used for an in-vehicle device, a mobile telephone and the like.

Additionally, in the case where the hot-melt adhesive comprises a saturated polyester resin which has a phthalic acid residue and a 1,4-butanediol residue, the content of the phthalic acid residue is in the range from 30% to 80% by mole based on 100% by mole of a total of dicarboxylic acid residues, and the content of the 1,4-butanediol residue is in the range from 30% by mole or more based on 100% by mole of a total of diol residues, the adhesive can lead to an adhesive tape with sufficient transparency and to a hot-melt adhesive for fixing an IC module with excellent solvent resistance, moist heat resistance, heat resistance and so on as well as flexibility.

Further, in the case where at least a part of the phthalic acid residue is a terephthalic acid residue, and (a × b) /100 is in the range from 30% to 55% by mole where the ratio of the terephthalic acid residue is a % by mole based on 100% by mole of a total of the dicarboxylic acid residues and the ratio of the 1,4-butanediol residue is b % by mole based on 100% by mole of a total of the diol residues, the hot-melt adhesive for fixing an IC module can have superior properties.

Furthermore, in the case where the adhesive of the invention further comprises an epoxy resin, the hot-melt adhesive for fixing an IC module can have superior visible light transmittance as well as bonding strength.

Moreover, in the case where the epoxy resin is a bisphenol A-type epoxy resin, the hot-melt adhesive for fixing an IC module can have superior bonding strength, solvent resistance, moist heat resistance, heat resistance and the like.

Additionally, in the case where the epoxy resin is contained in an amount from 3 to 30 parts by weight based on 100 parts by weight of the saturated polyester resin, the hot-melt adhesive for fixing and IC module can fully improve visible light transmittance, bonding strength, solvent resistance, moist heat resistance, heat resistance and the like.

In the laminated tape of the present invention, an IC chip disposed in a predetermined position can be easily detected since the adhesive tape has sufficient transparency.

In addition, in the case where the IC module substrate tape is formed using a saturated polyester resin, a conventional adhesive tape sometimes cannot bond with sufficient bonding strength. However, the adhesive tape formed using the hot-melt adhesive for fixing an IC module of the invention allows bonding with the IC module substrate tape having more sufficient adhesive strength, thereby forming a laminated tape with excellent quality.

According to the IC card of the present invention, an IC module is sufficiently firmly fixed in a card body, and the IC module neither detaches nor falls off the card body even if the card is used repeatedly.

Additionally, in the case where the card body is formed using a saturated polyester resin, a conventional adhesive sometimes cannot bond with sufficient bonding strength. However, the adhesive layer formed using the hot-melt adhesive for fixing an IC module of the invention allows bonding to the card body with more sufficient adhesive strength, thereby forming a IC card with excellent quality.

### [BRIEF DESCRIPTION OF THE DRAWINGS]

Fig. 1 is a schematic view showing a process in which an IC module tape and an adhesive tape are respectively drawn out to be bonded together to form a laminated tape, and then an IC chip is detected, and subsequently a laminate having an IC module and an adhesive layer is cut out from the laminated tape.
Fig. 2 is a schematic view showing a section of the IC module tape.
Fig. 3 is a schematic view showing a section of the adhesive tape in which a releasing material is laminated on the other side.
Fig. 4 is a schematic view showing a section of the laminated tape which is formed by laminating the IC module tape and the adhesive tape.
Fig. 5 is a perspective view of an IC card.
Fig. 6 is an A-A' section of Fig. 5, and a schematic view showing a state where an IC module is bonded and fixed in a recessed part of the card body by the adhesive layer.
Fig. 7 is a plan view of a card body for testing which has an opening in a central part and a stepped part arranged on the peripheral edge thereof.
Fig. 8 is a schematic view showing a state where the bonding strength when an IC module for testing is bonded to the card body for testing by the adhesive layer for testing is measured.

### [EXPLANATION OF THE REFERENCE NUMBERS]

1: IC card, 11: Card body, 12: IC module, 12a: IC module substrate, 12b: IC chip, 12c: Sealing part, 13: Adhesive layer, T: Laminated tape, 121: IC module tape, 121a: IC module substrate tape, 131: Adhesive tape, 131a: Releasing material tape, 31: Feeding roll, 32: Heater, 33: Detector, 34: Punching machine, 4: Test body, 41: Card body for testing, 411: Opening part, 412: Stepped part, 42: IC module for testing, 421: IC module substrate, 422: IC chip, 423: Sealing part, 43: Adhesive layer for testing, 5: Probe

### [BEST MODE FOR CARRYING OUT THE INVENTION]

Hereinafter, the present invention is described in detail.

### 1. Hot-melt Adhesive for Fixing IC Module

The hot-melt adhesive for fixing an IC module of the present invention is characterized in that the adhesive comprises a saturated polyester resin having a heat of fusion in the range from 8 mJ/mg to 25 mJ/mg and has a transmittance of 5% or higher when a film of the adhesive having a thickness of 30 µm is subjected to measurement by a visible light at a wavelength of 600 nm.

The above-mentioned "heat of fusion" of the saturated polyester resin is in the range from 8 mJ/mg to 25mJ/mg, preferably 10 mJ/mg to 25 mJ/mg, and particularly 10 mJ/mg to 20 mJ/mg. When this heat of fusion is in the range from 8 mJ/mg to 25 mJ/mg, the resin leads to a hot-melt adhesive for fixing an IC module having sufficient transparency, excellent solvent resistance, moist heat resistance, heat resistance, and so on. Additionally, this also suppresses reduction of workability due to fusion bonding to a punching blade or the like by increased temperature in cutting out IC modules from a laminated tape.

The heat of fusion can be measured using a differential scanning calorimeter by a method according to JIS K 7122-1987. The details of the measurement conditions are described in Examples below.

The transparency of the hot-melt adhesive for fixing an IC module can be expressed by the "visible light transmittance". The visible light transmittance is 5% or higher, preferably 10% or higher, more preferably 15% or higher, and particularly 20% or higher. When the visible light transmittance is 5% or higher, an IC chip disposed in an IC module tape can be detected easily.

Incidentally, in the case where the IC chip is covered with a sealing resin, the IC chip may be confirmed by detecting the sealing part.

The visible light transmittance can be measured using a spectrophotometer. The details of the measurement conditions are described in Examples below.

The above-mentioned "saturated polyester resin" can be produced by polycondensing a dicarboxylic acid and a diol.

The dicarboxylic acid is not particularly limited, and examples thereof include an aromatic dicarboxylic acid such as orthophthalic acid, isophthalic acid, terephthalic acid and 2,6-naphthalene dicarboxylic acid; an aliphatic dicarboxylic acid such as adipic acid, sebacic acid, azelaic acid and dodecanedioic acid; an alicyclic dicarboxylic acid such as 1,3-cyclohexane dicarboxylic acid and 1,4-cyclohexane dicarboxylic acid; and the like. The dicarboxylic acid may be used singly or in combination of two or more thereof. Among these, terephthalic acid, isophthalic acid, and an aliphatic dicarboxylic acid having carbon atoms of 5 to 11, particularly 5 to 10 such as adipic acid and sebacic acid are often used. In addition, it is preferable that terephthalic acid and/or isophthalic acid and an aliphatic dicarboxylic acid having carbon atoms of 5 to 11, particularly 5 to 10 are used in combination as the dicarboxylic acid. And the preferred is a combination of terephthalic acid and an aliphatic dicarboxylic acid having carbon atoms of 5 to 11 and particularly 5 to 10. Instead of the dicarboxylic acid, an acid anhydride, an ester, an acid chloride and the like can be used.

The diol is not particularly limited either, and examples thereof include 1,4-butanediol, 1,6-hexanediol, 1,4-cyclohexane diol, ethylene glycol, diethylene glycol, propylene glycol, neopentyl glycol and the like. The diol may be used singly or in combination of two or more types thereof. Among these, an alkyl diol having carbon atoms of 3 to 6 such as 1,4-butanediol and 1,6-hexanediol is often used. Additionally, the diol is preferably an alkyl diol having carbon atoms of 3 to 5, and is particularly 1,4-butanediol.

This saturated polyester resin may be a resin having a phthalic acid residue and a 1,4-butanediol residue, wherein the content of the phthalic acid residue is in the range from 30% to 80% by mole based on 100% by mole of a total of dicarboxylic acid residues, and the content of the 1,4-butanediol residue is 30% by mole or more (it may be 100% by mole) based on 100% by mole of a total of diol residues. This saturated polyester resin can be produced by using at least a phthalic acid as a dicarboxylic acid and at least 1,4-butanediol as a diol in a predetermined weight ratio.

Additionally, it is preferable that, in the saturated polyester resin having the above-mentioned specific composition, at least a part of the phthalic acid residue is a terephthalic acid residue, and (a × b)/100 is in the range from 30% to 55% by mole where the ratio of the terephthalic acid residue is a % by mole based on 100% by mole of a total of the dicarboxylic acid residues and the ratio of the 1,4-butanediol residue is b % by mole based on 100% by mole of a total of the diol residues. That is, this resin is a resin which is obtained using at least a terephthalic acid as a dicarboxylic acid and at least 1,4-butanediol as a diol, and is one in which the ratio of residues derived from these monomers is high. In this way, when ratios of the terephthalic acid residue and the 1,4-butanediol residue are high, the resin can be a saturated polyester having a predetermined heat of fusion, that is, having crystallinity.

The melting point and the glass transition point of the saturated polyester resin are not particularly limited. The melting point, which is not constantly correlated with the heat of fusion of the saturated polyester resin and the visible light transmittance of the hot-melt adhesive for fixing an IC module, is normally in the range from 105°C to 135°C, and particularly preferably 110°C to 130°C. The glass transition point is preferably ordinary temperature (25°C to 30°C) or lower, more preferably -40°C to ordinary temperature, and particularly preferably -20°C to ordinary temperature. Such a saturated polyester resin is easily crystallized at around ordinary temperature and thus can be a resin having blocking resistance. Furthermore, if a saturated polyester resin has a glass transition point within this range, the resin can be a hot-melt adhesive for fixing an IC module having moderate flexibility at ordinary temperature and excellent following property to the bend. This can also sufficiently suppress the aforementioned reduction of workability when an IC module and an adhesive layer are cut out from a laminated tape.

A hot-melt adhesive for fixing an IC module is formed by blending an epoxy resin with the saturated polyester resin. When the epoxy resin is blended, visible light transmittance, bonding strength, solvent resistance, moist heat resistance, heat resistance and the like can be further improved. The hot-melt adhesive for fixing an IC module of the present invention has an excellent adhesive property without blending the epoxy resin. However, especially in the case where an IC module tape is composed of a polyester resin, it is preferable to blend an epoxy resin for further improving bonding strength and the like.

The epoxy resin is not particularly limited, and examples thereof include a bisphenol-type epoxy resin, a novolac-type epoxy resin and the like. This epoxy resin is preferably a bisphenol A-type epoxy resin. Meanwhile, it is preferable that the epoxy resin has a softening point of 60°C to 140°C and a weight-average molecular weight of 700 to 6,000. Therefore, the bisphenol A-type epoxy resin having a softening point of 60°C to 140°C and a weight-average molecular weight of 700 to 6,000 is particularly preferable. If an epoxy resin has the softening point of 60°C to 140°C and the weight-average molecular weight of 700 to 6,000, the hot-melt adhesive for fixing an IC module neither has a tacking property at ordinary temperature nor causes thermal deformation and the like of an IC module substrate tape, thereby forming an IC card of high quality.

In the case of blending an epoxy resin, the blending amount thereof is preferably in the range from 3 to 30 parts by weight, more preferably from 3 to 25 parts by weight, further preferably from 5 to 20 parts by weight, and particularly 7 to 15 parts by weight based on 100 parts by weight of the saturated polyester resin, regardless of the type of the epoxy resin. In the case where the blending amount of the epoxy resin is in the range from 3 to 30 parts by weight, even though when the IC module substrate tape is composed of a saturated polyester resin, this IC module substrate tape can be bonded more firmly to a card body.

A hot-melt adhesive for fixing an IC module can be one obtained blending an inorganic filler with the saturated polyester resin. Blend of the inorganic filler leads to further improvements on fluidity before curing, thermal deformation and non-tacking property after curing, and the like. The inorganic filler is not particularly limited, and examples thereof include powders composed of as calcium carbonate, zinc oxide, titanium oxide, talc, clay, alumina, fumed silica, mica, aluminum hydroxide, magnesium hydroxide or the like. The inorganic filler are preferably ones of talc, calcium carbonate, clay and the like.

The visible light transmittance varies according to the type of the inorganic filler, a particle size thereof, a difference between refractive indices of the inorganic filler and the saturated polyester resin or the like, a dispersion state of the inorganic filler in the saturated polyester resin, and the like. Therefore, the visibility cannot be estimated and adjusted only based on the blending amount of the inorganic filler, however, if too much inorganic filler is blended, it is difficult to improve the visibility. Therefore, in the case where the inorganic filler is blended, the blending amount is preferably 25 parts by weight or less, more preferably 1 to 20 parts by weight, and particularly 1 to 15 parts by weight based on 100 parts by weight of the saturated polyester resin. If the blending amount of the inorganic filler is 25 parts by weight or less, particularly 15 parts by weight or less, the adhesive tape can have sufficient visible light transparency and thereby an IC chip can be easily detected.

The hot-melt adhesive for fixing an IC module of the present invention also has high heat resistance and excellent workability when a large number of IC modules are cut out continuously from a laminated tape by punching and the like. Therefore, it is not necessary to blend a large amount of inorganic fillers for the purpose of improving the workability. It is preferable that the inorganic filler is blended in an amount of 3 parts by weight or more, and particularly 5 parts by weight or more (usually 15 parts by weight or less) in order to further improve workability.

Both the epoxy resin and the inorganic filler can be blended and contained in a hot-melt adhesive for fixing an IC module. In this case, with regard to the type of the epoxy resin and the blending amount thereof, and the type of the inorganic filler and the blending amount thereof, the above-mentioned descriptions concerning respectively the epoxy resin and the inorganic filler can be applied without any change.

In the hot-melt adhesive for fixing an IC module, various kinds of additives other than the epoxy resin and the inorganic filler can be blended as required unless the function and the effect thereof are not imparted. Examples of the additives include a plasticizer, an antioxidant, an ultraviolet absorber, a coloring agent, an adhesion inhibitor, a stabilizer, a mold releasing agent, a metal deactivator, an antistatic agent, and other fillers except the inorganic filler mentioned above.

The method for manufacturing a hot-melt adhesive for fixing an IC module is not particularly limited. However, the adhesive can be manufactured using an ordinary mixer for a thermoplastic resin typified by, for example, a single or a twin screw extruder, and a kneader-type heating kneader. Besides, in the case where the epoxy resin, the inorganic filler and various additives are blended and mixed with the saturated polyester resin, these are preferably melt and mixed at the temperature equal or higher than the respective softening temperature of the saturated polyester resin and the epoxy resin used.

### 2. Laminated Tape

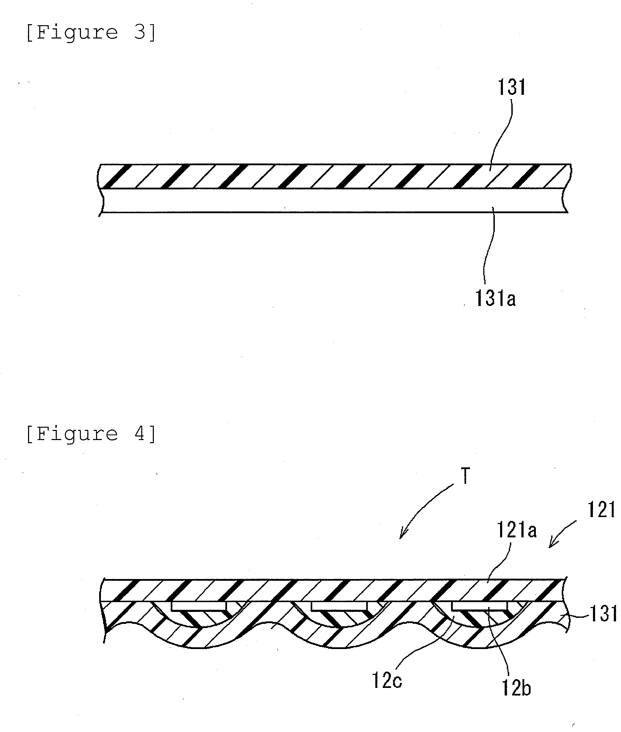

The laminated tape T of the present invention comprises an IC module tape 121 having an IC module substrate tape 121a on which a plurality of circuit patterns are arranged in a length direction at intervals, IC chips 12b which are disposed on a surface of the IC module substrate tape and are electrically connected with the respective circuit patterns, the number of which corresponds to the number of the IC chips, and sealing parts 12c that seal the respective IC chips 12b, and an adhesive tape 131 which is formed using the hot-melt adhesive for fixing an IC module of the present invention and is bonded to the surface of the IC module substrate tape 121a and to respective sealing parts 12c (see Fig. 4).

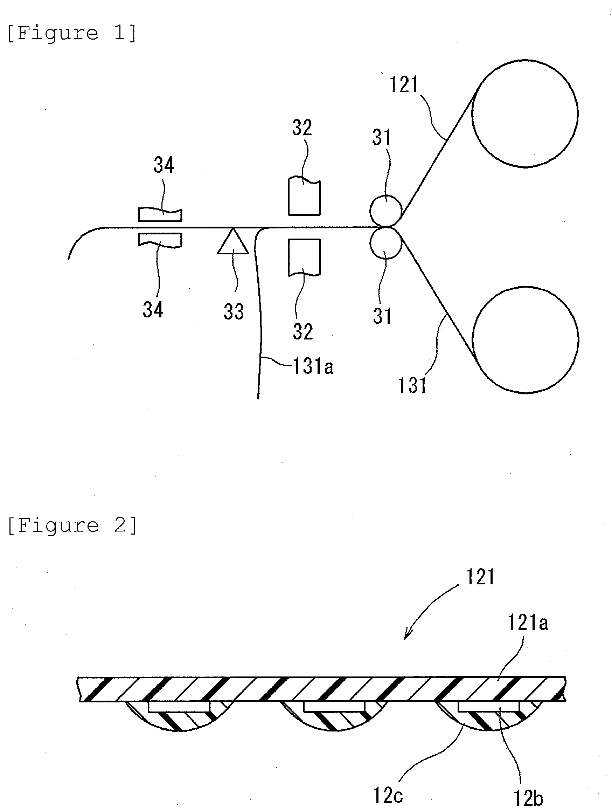

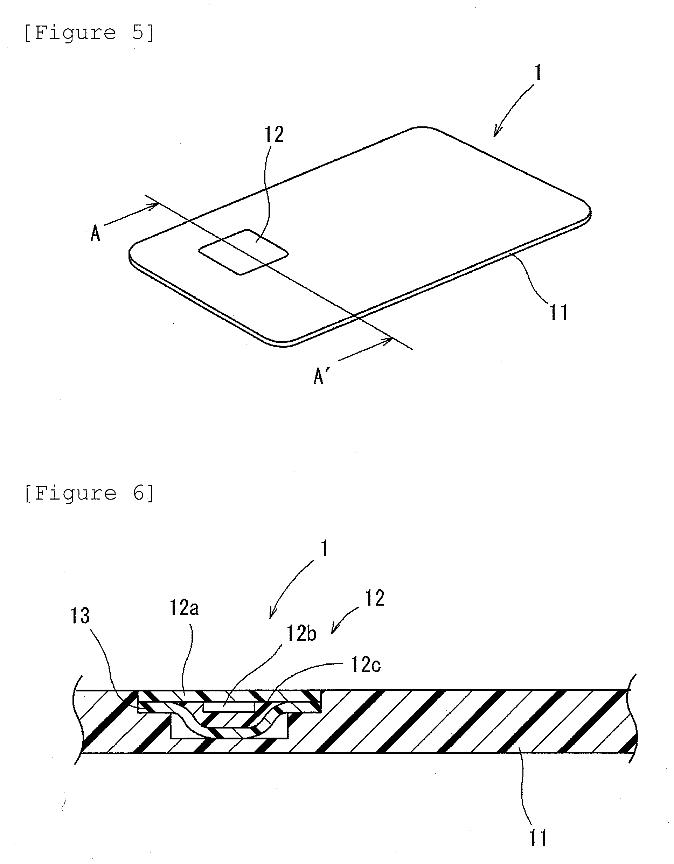

The above-mentioned "IC module tape 121" has an IC module substrate tape 121a, an IC chip 12b, and a sealing part 12c (see Fig. 2). The IC chip 12b is not particularly limited so long as it is an IC chip generally used for an IC card 1 (see Figs. 5 and 6). The material of the sealing part 12c and the sealing method are not particularly limited so long as they are a sealing material and a sealing method that are generally used in manufacturing the IC card 1. In addition, the material of the IC module substrate tape 121a and the circuit pattern are not particularly limited. When the IC module substrate tape 121a is formed using a saturated polyester resin, the present invention exhibits more remarkable function and effect. More specifically, in the case where the IC module substrate tape 121a is composed of a glass epoxy or the like, the IC module 12 can be firmly bonded to the card body 11 shown in Fig. 5 and 6 with an adhesive of a polyamide-based adhesive, a nitrile rubber-based adhesive or the like. However, the IC module substrate tape 121a formed using a saturated polyester resin is sometimes insufficiently bonded with the adhesive of a polyamide-based adhesive, a nitrile rubber-based adhesive or the like. On the contrary, with the hot-melt adhesive for fixing an IC module of the present invention, even in the case where the IC module substrate tape 121a is formed using a saturated polyester resin, the IC module 12 can be bonded more firmly to the card body 11.

The above-mentioned "adhesive tape 131" is formed using the hot-melt adhesive for fixing an IC module of the present invention to mold into a tape. The width thereof is the same as that of the IC module tape 121, and the thickness thereof is preferably in the range from 20 to 100 µm, and particularly 30 to 70 µm (see Fig. 3).

### 3. IC Card

The IC card 1 of the present invention comprises a card body 11, an IC module 12 (see Figs. 5 and 6) which is cut out from the IC module tape 121 in the laminated tape T of the present invention (see Fig. 4), and an adhesive layer 13 (see Fig. 6) which is cut out together with the IC module 12 from the adhesive tape 131 in the laminated tape T and bonds the card body 11 and the IC module 12.

The shape and dimension of the above-mentioned "card body 11" may be those generally used for an IC card 1, and are not particularly limited. The material of the card body 11 is not particularly limited, either. When the card body 11 is formed using a saturated polyester resin, the present invention exhibits more remarkable function and effect. More specifically, when the card body 11 is composed of vinyl chloride, an ABS resin or the like, the card body 11 can be firmly bonded with the IC module 12 with an adhesive of a polyamide-based adhesive, a nitrile rubber-based adhesive or the like. However, the card body 11 formed using a saturated polyester resin is sometimes insufficiently bonded with the adhesive of a polyamide based-adhesive, a nitrile rubber-based adhesive or the like. On the contrary, with the hot-melt adhesive for fixing an IC module of the present invention, even in the case where the card body 11 is formed using the saturated polyester resin, the card body 11 and the IC module 12 can be bonded together more firmly with the adhesive layer 13.

### 4. Production of IC Module Using Laminated Tape and Manufacture of IC Card

The method for producing an IC module 12 (see Figs. 5 and 6) using a laminated tape T shown in Fig. 4 is not particularly limited. The method, for example, comprises: drawing out an IC module tape 121 wound around a core body shown in Fig. 2 and an adhesive tape 131 on one surface of which a releasing material tape 131a is laminated and wound around a core body shown in Fig. 3 at the same time; sandwiching these tapes between a pair of feeding rolls 31 so that, on a surface of the IC module tape 121 on which an IC chip 12b is disposed, the adhesive tape 131 is laminated in the state that a releasing material tape 131a is laminated thereon; heating these tapes by a heater 32 to be temporarily adhered each other; removing the releasing material tape 131a; irradiating detection light onto the adhesive tape 131 side from a detector 33 to detect an IC chip 12b disposed on the IC module tape 121; and then continuously punching out an IC module 12 by a punching machine 34. Thus, the IC module 12 with which the adhesive layer 13 is bonded can be produced (see Figs. 1 and 6).

The method for manufacturing the IC card 1 is not particularly limited, either. The IC card 1 can be manufactured by the method, for example, comprising: locating a card body 11 and a IC module 12 at a predetermined position so that a peripheral edge of the adhesive layer 13 bonded to the IC module 12 is abutted to a stepped part of the card body 11 having a recessed part and the stepped part which is formed on a peripheral edge thereof (see Fig. 6); pressing on this abutted part a heating surface of a heater having a predetermined shape to heat and exert pressure at a predetermined temperature for a predetermined duration; and thereby bonding the IC module 12 to the card body 11.

The temperature, pressure and duration for the above-mentioned heating and pressurization are not particularly limited. The temperature is preferably in the range from 150°C to 230°C, more preferably 170°C to 210°C, and particularly 180°C to 200°C. The pressure is preferably in the range from 0.05 to 0.35 MPa, more preferably 0.07 to 0.30 MPa, and particularly 0.09 to 0.20 MPa. The duration is preferably in the range from 0.5 to 2 seconds, more preferably 0.7 to 1.5 seconds, and particularly 0.9 to 1.3 seconds. These temperature, pressure and duration can be set as an assortment thereof. It is particularly preferable that the temperature is 180°C to 200°C, the pressure is 0.09 to 0.11 MPa, and the duration is 0.9 to 1.3 seconds. Furthermore, this heating and pressurization can be performed only one time, or may be continuously repeated several times (preferably two or three times, particularly twice), as required.

The IC module 12 is bonded to the card body 11 in the described manner, and although the IC module 12 and an inner surface of the recessed part of the card body 11 are not generally bonded, or not sufficiently bonded, the IC module 12 neither detaches nor falls off the main body 11.

Incidentally, since it is not being bonded inside or not being sufficiently bonded, as just mentioned, the IC module 12 can be prevented from detaching and falling off the card body 11 and the IC chip 12b can be prevented from being damaged, when the IC card 1 is bent.

### [EXAMPLES]

Hereinafter, the present invention is concretely explained with reference to Examples.

### 1. Saturated Polyester Resin

With the saturated polyester resins (A) to (F) having the respective monomer compositions described in Table 1, the hot-melt adhesives for fixing an IC module were manufactured. The heat of fusion and the other properties of saturated polyester resins were measured according to the following description.

### (1) Heat of fusion and melting point

A differential scanning calorimeter was used to measure according to JIS K 7122-1987.

For standard state adjustment, a sample was left at rest in a 23 ± 2°C and 50 ± 5% RH atmosphere for 24 hours before the measurement, and then the measurement was carried out.
Measurement device: Differential scanning calorimeter (type "RDC220" manufactured by SEICO Instruments Inc.)
Workstation: "SSC5200"
Device calibration substance: Indium
Measurement condition: Under nitrogen gas stream, using an aluminum pan, a sample weight of 7.5 ± 2.5 mg
Measurement method: The temperature was cooled down from ordinary temperature to -70°C, this temperature was maintained for five minutes, and then was raised to 200°C at a temperature raising rate of 10 ± 0.5°C/min to obtain a DSC curve. Subsequently, on this curve, before and after the transition, the point where the curve is apart from the baseline and the point where the curve returns to the baseline were connected each other with a straight line to form a graphic together with a peak of heat of fusion. The area of the thus-formed graphic was obtained. Then a heat of fusion was calculated by a workstation associated with the measurement device.

Incidentally, when there was a plurality of peaks of heat of fusion, the heat of fusion of each of the peaks of heat of fusion was calculated as described above. The respective values were added up and the resulting value was employed as the heat of fusion of the hot-melt adhesive for fixing an IC module.

Meanwhile, the temperature corresponding to the peak of heat of fusion on the highest temperature side among the peaks of heat of fusion was employed as a melting point.

### (2) Glass transition point

The glass transition point was measured using the differential scanning calorimeter described in the above-mentioned (1) by a method according to JIS K 7121-1987. The temperature was increased from ordinary temperature to 200°C, this temperature was maintained for ten minutes, and then was rapidly cooled to -70°C and this temperature was maintained for ten minutes, and subsequently was increased to 50°C at a temperature raising rate of 10 ± 0.5°C/min to obtain a DSC curve. From this DSC curve the glass transition point was obtained.

The results are also included in Table 1.

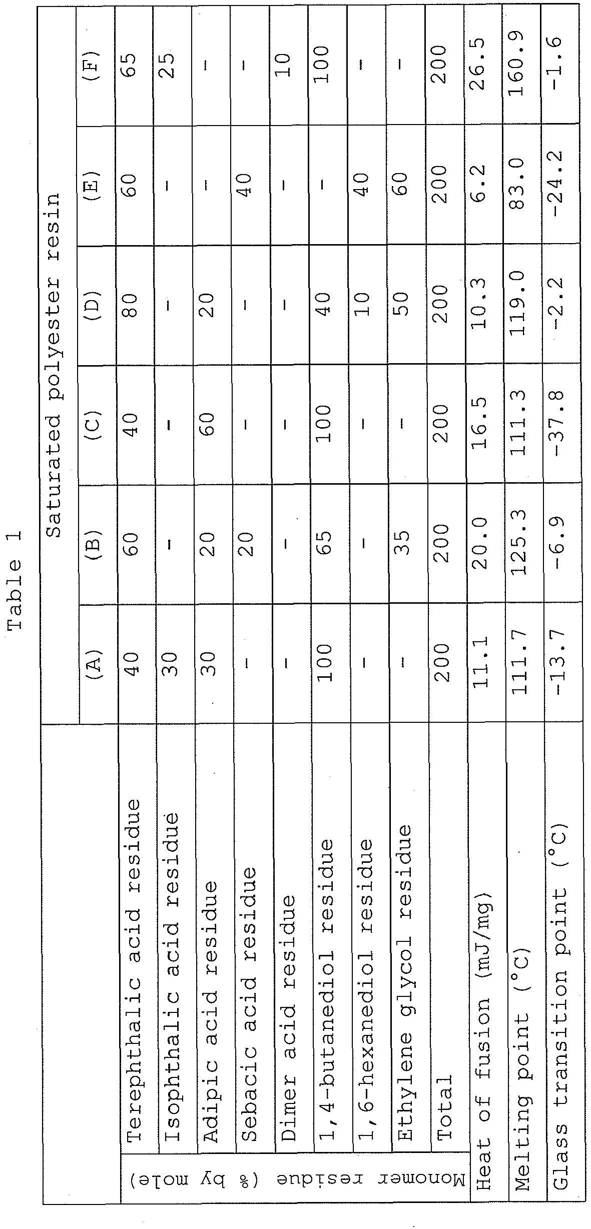

The results in Table 1 show that, the saturated polyester resins (A), (B), (C) and (D) in which molar ratio of a terephthalic acid residue to a 1,4-butanediol residue is within a predetermined range have heats of fusion within the range of the present invention and the glass transition points thereof are also within a preferable range. On the contrary, with regard to the saturated polyester resin (E) which does not have a 1,4-butanediol residue, the heat of fusion is excessively small. In addition, with regard to the saturated polyester resin (F) which has a large amount of phthalic acid residues, the heat of fusion is excessively large.

### 2. Hot-melt Adhesive for Fixing IC Module

### Examples 1 to 8 and Comparative Examples 1 to 3

The saturated polyester resin described in Table 1, an epoxy resin, an inorganic filler and a hydrolysis inhibitor were used at the amount ratio described in Table 2 and Table 3 to manufacture the hot-melt adhesive for fixing an IC module by a twin screw extruder.

As the epoxy resin, the inorganic filler and the hydrolysis inhibitor, the followings were used respectively.
Epoxy resin: Bisphenol A-type "EP-1007" (trade name) manufactured by Japan Epoxy Resins Co., Ltd.
Inorganic filler: Talc "RKP-80" (trade name) manufactured by Fuji Fine Ltd.
Hydrolysis inhibitor: Polycarbodiimide "NPE" (trade name) manufactured by Sumika Bayer Urethane Co., Ltd.

The hot-melt adhesives for fixing an IC module were evaluated according to the following description.

### (1) Visible light transmittance

Transmittance was measured with a spectrophotometer at a wavelength of 600 nm.
Measurement device: Spectrophotometer (type "UV2400PC" manufactured by Shimadzu Corporation)
Source of light: Halogen lamp of 50 W (wavelength 800-370 nm) and Heavy hydrogen lamp (wavelength 370-190 nm)
Measurement method: The hot-melt adhesives for fixing an IC module was subjected to mold a film of thickness 30 µm with a T-die extruder. The film was scanned at the rate of 210 nm/min in the wavelength range from 800 nm to 190 nm to measure the transmittance at a wavelength of 600 nm.

### (2) IC chip visibility

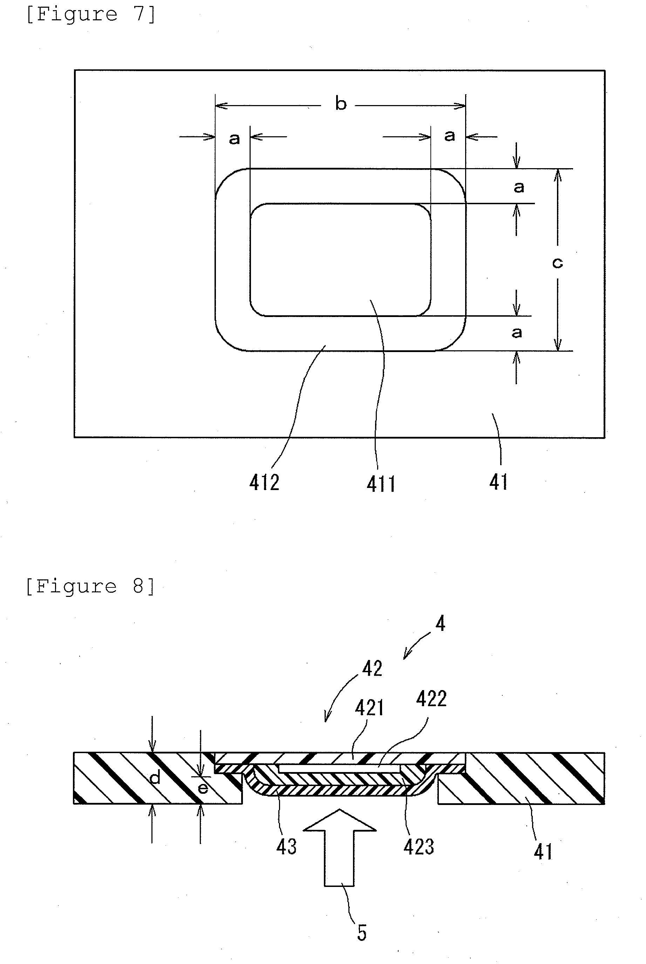

An adhesive layer for testing 43 molded into a thickness of 30 µm using the hot-melt adhesive for fixing an IC module by a T-die extruder was laminated on a surface of an IC module for testing 42 on which the IC chip is disposed and temporarily adhesion was carried out heating and exerting pressure at a temperature of 130°C and a pressure of 0.5 MPa for two seconds. After that, the adhesive layer for testing 43 and the IC module substrate 421 were so located that the peripheral edges thereof were respectively fitted into a stepped part 412 of the card body for testing 41 shown in Fig. 7 which was made from PETG (a saturated polyester resin having a terephthalic acid residue, an ethylene glycol residue, and cyclohexanedimethanol residue; trade name "EASTER GN071" manufactured by Eastman Chemical Company) and in which an opening part 411 and the stepped part 412 were arranged. They were heated and exerted pressure at a temperature of 190°C and 0.36 MPa for two seconds to properly adhere, thereby producing a test body 4 (see Fig. 8). Subsequently, the test body 4 was visually observed from the adhesive layer for testing 43 side. In the evaluation results in Tables 2 and 3, "○" means that the profile of the sealing part 423 was clearly visible, and "x" means that the profile was not visible.

### (3) Initial bonding strength

A test body 4 was produced as was the case with the above-mentioned (2). Then, the IC module for testing 42 was pushed out at the push-out speed of 50 mm/min by a probe 5 from the opposite side of the surface where the module 42 was adhered, to measure the initial bonding strength (see Fig. 8).

It is noted that in Fig. 7, a is 2.0 mm, b is 13.0 mm, and c is 12.0 mm. Furthermore, in Fig. 8, d is 0.76 mm and e is 0.55 mm.

### (4) Solvent resistance

The test body 4 produced in the same manner as the above-mentioned (2) was subjected to dipping in a 25°C ethanol aqueous solution at a concentration of 60% by weight or in a 25°C mixed solution of isooctane/toluene=70/30 (weight ratio) for 24 hours, and then the bonding strength (unit: N) was measured in the same manner as the above-mentioned (3) to evaluate the solvent resistance.

### (5) Moist heat resistance

A test body 4 produced in the same manner as the above-mentioned (2) was exposed to 60°C and 90% RH atmosphere for 500 hours, and then the bonding strength (unit: N) was measured in the same manner as the above-mentioned (3) to evaluate the moist heat resistance.

### (6) Heat resistance

A test body 4 produced in the same manner as the above-mentioned (2) was exposed to a high temperature atmosphere of 95°C for 500 hours, and then the bonding strength (unit: N) was measured in the same manner as the above-mentioned (3) to evaluate the heat resistance.

Meanwhile, as Comparative Examples 4 and 5, the following commercial hot-melt adhesives for fixing an IC module were used to evaluate the physical properties in the same manner.
Comparative Example 4: Nitrile phenolic rubber based (trade name "HAF-8410" manufactured by Tesa Corp.).
Comparative Example 5: Modified polyamide based (trade name "Cadel70-1" manufactured by Cadel Corp.).

The evaluation results of the above-mentioned (1) to (6) are included in Tables 2 and 3 (The evaluation results of the above-mentioned (4) to (6) are described in the expression of "durability" in Tables 2 and 3.).

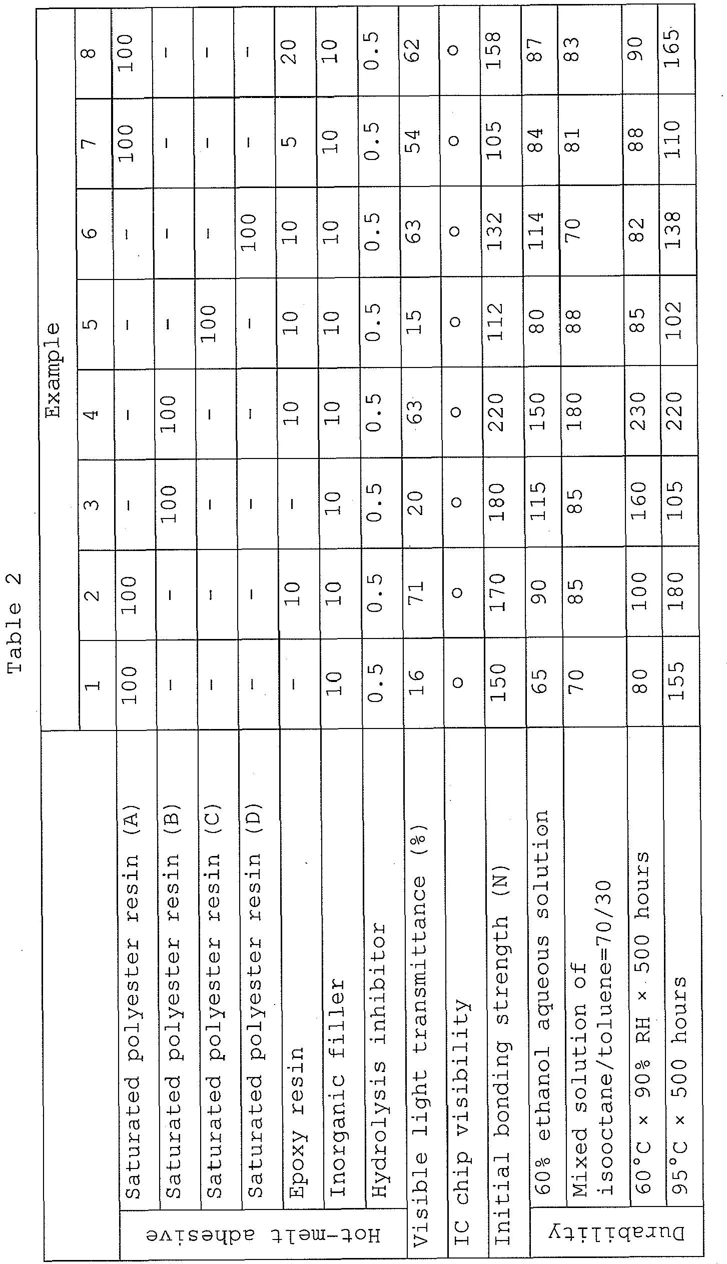

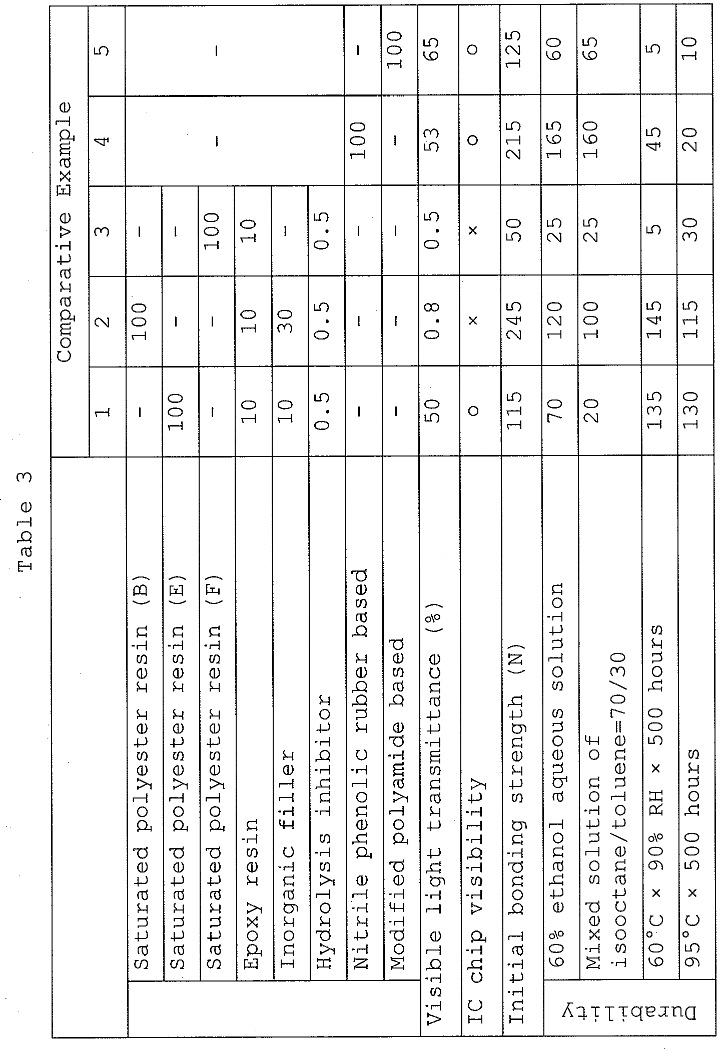

The results of Table 2 show that the hot-melt adhesives for fixing an IC module in Examples 1 to 8 using the saturated polyester resins (A), (B), (C) and (D) had excellent visibility of an IC chip and at the same time had sufficient initial bonding strength and durability of the bonding strength. The results also show that visible light transmittances were improved in the hot-melt adhesives for fixing an IC module in Examples 2 and 4, which contain 10 parts by weight of an epoxy resin, thereby having excellent visibility of an IC chip and leading to further improvement on both initial bonding strength and durability of the bonding strength. Further, Example 7, which contains 5 parts by weight of an epoxy resin, exhibited lower initial bonding strength, but had excellent durability of the bonding strength and improvement on visible light transmittance. Additionally, Example 8, which contains 20 parts by weight of an epoxy resin, did not show further improved adhesion performance in comparison with Examples 2 and 4, but had excellent initial bonding strength and durability and improvement on visible light transmittance.

On the other hand, according to the results of Table 3, Comparative Example 1 using the saturated polyester resin (E) having an excessively small heat of fusion, had no problem with regard to visibility of an IC chip, but exhibited significantly lower initial bonding strength and durability of the bonding strength. Comparative Example 2, of which composition is the same as that of Example 4 except for a large content, 30% by weight, of the inorganic filler, had poor visibility of an IC chip. Furthermore, Comparative Example 3, using the saturated polyester resin (F) having an excessively large heat of fusion, despite containing no inorganic filler, had poor visibility of an IC chip and exhibited significantly lower initial bonding strength and durability of the bonding strength. From the viewpoint, it is found that the heat of fusion exceeding an upper limit is particularly a critical problem.

Incidentally, Comparative Examples 4 and 5, using the conventional hot-melt adhesives for fixing an IC module, had no problem on visibility of an IC chip, but especially exhibited significantly lower moist heat resistance and heat resistance.

## Claims

1. A hot-melt adhesive for fixing an IC module in a laminated IC module tape **characterized in that** said adhesive comprises a saturated polyester resin having a heat of fusion in the range from 8 mJ/mg to 25 mJ/mg and has a transmittance of 5% or higher when a film of said adhesive having a thickness of 30 µm is subjected to measurement by a visible light at a wavelength of 600 nm.

2. The hot-melt adhesive for fixing an IC module according to Claim 1,
wherein said adhesive comprises a saturated polyester resin which has a phthalic acid residue and a 1,4-butanediol residue,
wherein the content of said phthalic acid residue is in the range from 30% to 80% by mole based on 100% by mole of a total of dicarboxylic acid residues, and
wherein the content of said 1,4-butanediol residue is in the range from 30% by mole or more based on 100% by mole of a total of diol residues.

3. The hot-melt adhesive for fixing an IC module according to Claim 2,
wherein at least a part of said phthalic acid residue is a terephthalic acid residue, and
wherein (a × b)/100 is in the range from 30% to 55% by mole where the ratio of said terephthalic acid residue is a % by mole based on 100% by mole of a total of said dicarboxylic acid residues and the ratio of said 1,4-butanediol residue is b % by mole based on 100% by mole of a total of said diol residues.

4. The hot-melt adhesive for fixing an IC module according to any one of Claims 1 to 3, further comprising an epoxy resin.

5. The hot-melt adhesive for fixing an IC module according to Claim 4,
wherein said epoxy resin is a bisphenol A-type epoxy resin.

6. The hot-melt adhesive for fixing an IC module according to Claim 5,
wherein said epoxy resin is contained in an amount from 3 to 30 parts by weight based on 100 parts by weight of said saturated polyester resin.

7. A laminated tape **characterized by** comprising,
an IC module tape that has an IC module substrate tape on which a plurality of circuit patterns are arranged in a length direction at intervals, IC chips which are disposed on a surface of said IC module substrate tape and are electrically connected with said respective circuit patterns, the number of which corresponds to the number of said IC chips, and a sealing part which seals said respective IC chips, and
an adhesive tape that is formed using said hot-melt adhesive for fixing an IC module according to any one of Claims 1 to 6 and is bonded to the surface of said IC module substrate tape and to said respective sealing parts.

8. The laminated tape according to Claim 7,
wherein said IC module substrate tape is formed using a saturated polyester resin.

9. An IC card **characterized by** comprising,
a card body,
an IC module which is cut out from said IC module tape in said laminated tape according to Claim 7 or 8, and
an adhesive layer which is cut out together with said IC module from said adhesive tape in said laminated tape and bonds said card body and said IC module.

10. The IC card according to Claim 9,
wherein said card body is formed using a saturated polyester resin.

## Patentansprüche

1. Schmelzkleber für die Fixierung eines IC-Moduls in einem laminierten IC-Modulband, **dadurch gekennzeichnet, dass** der Kleber ein gesättigtes Polyesterharz mit einer Fusionswärme in dem Bereich von 8 mJ/mg bis 25 mJ/mg aufweist und eine Lichtdurchlässigkeit von 5% oder höher aufweist, wenn ein Film des Klebers mit einer Dicke von 30 µm einer Messung mit sichtbarem Licht bei einer Wellenlänge von 600 nm unterzogen wird.

2. Schmelzkleber für die Fixierung eines IC-Moduls nach Anspruch 1
wobei der Kleber ein gesättigtes Polyesterharz umfasst, welches einen Phthalsäurerest und einen 1,4-Butandiolrest aufweist,
wobei der Gehalt des Phthalsäurerests in dem Bereich von 30 mol-% bis 80 mol-% basierend auf 100 mol-% der Gesamtheit der Dicarbonsäurereste ist, und
wobei der Gehalt des 1,4-Butandiolrests in den Bereich von 30 mol-% oder mehr basierend auf 100 mol-% der Gesamtheit der Diolreste ist.

3. Schmelzkleber für die Fixierung eines IC-Moduls nach Anspruch 2,
wobei wenigstens ein Teil des Phthalsäurerests ein Terephthalsäurerest ist, und
wobei (a × b) / 100 in dem Bereich von 30 mol-% bis 55 mol-% ist, wobei a mol-% der Anteil des Terephthalsäurerests basierend auf 100 mol-% der Gesamtheit der Dicarbonsäurereste ist, und b mol-% der Anteil des 1,4-Butandiolrests basierend auf 100 mol-% der Gesamtheit der Diolreste ist.

4. Schmelzkleber für die Fixierung eines IC-Moduls nach einem der Ansprüche 1 bis 3, der außerdem ein Epoxyharz umfasst.

5. Schmelzkleber für die Fixierung eines IC-Moduls nach Anspruch 4,
wobei das Epoxyharz ein Epoxyharz vom Bisphenol A-Typ ist.

6. Schmelzkleber für die Fixierung eines IC-Moduls nach Anspruch 5,
wobei das Epoxyharz in einer Menge von 3 bis 30 Gewichtsteilen basierend auf 100 Gewichtsteilen des gesättigten Polyesterharzes enthalten ist.

7. Laminiertes Band, **dadurch gekennzeichnet, dass** es umfasst,
ein IC-Modulband, das ein IC-Modulsubstratband, auf welchem eine Mehrzahl von Schaltkreismustern in einer Längsrichtung in Intervallen angeordnet sind, IC-Chips, welche auf einer Oberfläche des IC-Modulsubstratbands angeordnet sind und elektrisch mit den entsprechenden Schaltkreismustern verbunden sind, wobei deren Anzahl der Anzahl der IC-Chips entspricht, und ein Versiegelungsteil aufweist, welches die entsprechenden IC-Chips versiegelt, und
ein adhäsives Band, das unter Verwendung des Schmelzklebers für die Fixierung eines IC-Moduls nach einem der Ansprüche 1 bis 6 gebildet ist und an die Oberfläche des IC-Modulsubstratbandes und die entsprechenden versiegelnden Teile gebunden ist.

8. Laminiertes Band nach Anspruch 7,
wobei das IC-Modulsubstratband unter Verwendung eines gesättigten Polyesterharzes gebildet ist.

9. IC-Karte, **dadurch gekennzeichnet, dass** sie umfasst,
einen Kartenkörper,
ein IC-Modul, welches ausgeschnitten aus dem IC-Modulband in dem laminierten Band nach Anspruch 7 oder 8 ist, und
eine adhäsive Schicht, welche zusammen mit dem IC-Modul aus dem adhäsiven Band in dem laminierten Band geschnitten ist, und den Kartenkörper und das IC-Modul verbindet.

10. IC-Karte nach Anspruch 9,
wobei der Kartenkörper unter Verwendung eines gesättigten Polyesterharzes gebildet ist.

## Revendications

1. Adhésif thermofusible pour fixer un module de circuit intégré (IC) dans un ruban de modules IC stratifié, **caractérisé en ce que** ledit adhésif comprend une résine de polyester saturé ayant une chaleur de fusion située dans la plage allant de 8 mJ/mg à 25 mJ/mg, et a un coefficient de transmission de 5 % ou plus quand un film dudit adhésif ayant une épaisseur de 30 µm est soumis à une mesure par une lumière visible à une longueur d'onde de 600 nm.

2. Adhésif thermofusible pour fixer un module IC selon la revendication 1,
dans lequel ledit adhésif comprend une résine de polyester saturé qui a un résidu d'acide phtalique et un résidu de 1,4-butanediol,
dans lequel la teneur en ledit résidu d'acide phtalique est située dans la plage allant de 30 % à 80 % en moles pour 100 % en moles du total des résidus d'acide dicarboxylique, et
dans lequel la teneur en ledit résidu de 1,4-butanediol est de 30 % en moles ou plus pour 100 % en moles du total des résidus de diol.

3. Adhésif thermofusible pour fixer un module IC selon la revendication 2,
dans lequel au moins une partie dudit résidu d'acide phtalique est un résidu d'acide téréphtalique, et
dans lequel la valeur de (a x b)/100 est située dans la plage allant de 30 % à 55 % en moles, où la proportion dudit résidu d'acide téréphtalique est de a % en moles pour 100 % en moles du total desdits résidus d'acide dicarboxylique, et la proportion dudit résidu de 1,4-butanediol est de b % en moles pour 100 % en moles du total desdits résidus de diol.

4. Adhésif thermofusible pour fixer un module IC selon l'une quelconque des revendications 1 à 3, comprenant en outre une résine époxy.

5. Adhésif thermofusible pour fixer un module IC selon la revendication 4, dans lequel ladite résine époxy est une résine époxy de type bisphénol A.

6. Adhésif thermofusible pour fixer un module IC selon la revendication 5, dans lequel ladite résine époxy est contenue en une quantité de 3 à 30 parties en poids pour 100 parties en poids de ladite résine de polyester saturé.

7. Ruban stratifié **caractérisé en ce qu'**il comprend
un ruban de modules IC qui a un ruban de substrats de modules IC sur lequel une pluralité de motifs de circuit sont agencés dans la direction de la longueur à intervalles donnés, des puces IC qui sont disposées sur une surface dudit ruban de substrats de modules IC et sont connectées électriquement auxdits motifs de circuit respectifs, dont le nombre correspond au nombre desdites puces IC, et une partie de scellement qui scelle lesdites puces IC respectives, et
un ruban adhésif qui est formé par utilisation dudit adhésif thermofusible pour fixer un module IC selon l'une quelconque des revendications 1 à 6 et est collé à la surface dudit ruban de substrats de modules IC et auxdites parties de scellement respectives.

8. Ruban stratifié selon la revendication 7, dans lequel ledit ruban de substrats de modules IC est formé par utilisation d'une résine de polyester saturé.

9. Carte IC **caractérisée en ce qu'**elle comprend
un corps de carte,
un module IC qui est découpé à partir dudit ruban de modules IC dans ledit ruban stratifié selon la revendication 7 ou 8, et
une couche adhésive qui est découpée conjointement avec ledit module IC à partir dudit ruban adhésif dans ledit ruban stratifié et colle ledit corps de carte et ledit module IC.

10. Carte IC selon la revendication 9, dans laquelle ledit corps de carte est formé par utilisation d'une résine de polyester saturé.
